# EUROPEAN PATENT APPLICATION

(11) **EP 4 750 240 A1**
(43) Date of publication of application: **27.05.2026**
(21) Application number: 25217437.0
(22) Date of filing: 20.11.2025
(51) Int. Cl.: H05K 7/20

(54) **AUTOMATED WATER CIRCULATION FOR COOLING UNITS**

(30) Priority: 22.11.2024 US 202463724080 P; 11.11.2025 US 202519385824
(71) Applicant: Vertiv Corporation, Westerville, OH 43082 (US)
(72) Inventor: BLASER, Colin Lewis, Westerville, 43082 (US); SCHUTTE, Daniel Joseph, Westerville, 43082 (US); RAVEN, Matthew Alan, Westerville, 43082 (US); MCCOY, Tracy Alan, Westerville, 43082 (US)
(74) Representative: Ambroz, Simon

(57) **Abstract**

A liquid cooling system may include a first heat exchanger configured to transfer heat from a liquid to a refrigerant. The liquid cooling system may include a coolant circuit configured to circulate liquid coolant between the first heat exchanger and at least one of electronic equipment or a cooling distribution unit, the coolant circuit comprising: a liquid coolant supply line coupled to the first heat exchanger and configured to flow chilled liquid coolant from the first heat exchanger, a coolant return line coupled to the first heat exchanger and configured to flow warmed coolant to the first heat exchanger; and a bypass line coupled to the liquid coolant supply line and the coolant return line.

## Description

### CROSS-REFERENCE TO RELATED APPLICATIONS

The present application claims the benefit under 35 U.S.C § 119(e) to U.S. Provisional Application No. 63/724,080, filed November 22, 2024, and to U.S. Nonprovisional application 19/385,824, filed November 11, 2025.

### TECHNICAL FIELD

The present disclosure relates to cooling systems for electronic equipment, and more particularly, to cooling systems using hybrid liquid cooling technologies.

### BACKGROUND

Telecommunication and computing industries rely on cooling systems to keep temperature-sensitive equipment (e.g., servers, computers) operating under rated or normal environmental conditions. While the first cooling systems were based on heat exchangers that relied on airflow, newer systems often utilize liquid cooling systems for heat transfer. Many companies are looking to either update legacy air cooling systems with liquid cooling or switch over to liquid cooling systems completely. One problem that liquid cooling units often have is their tendency to retain liquid coolant, such as water or a PG-25 coolant, inside the cooling system when the liquid cooling unit is not in use, or when the cooling system is switching from liquid cooling to air cooling. This trapping of the liquid refrigerant can cause the liquid to stagnate and break down, resulting in sediment and other breakdown materials that shorten the lifespan of the cooling system.

Accordingly, it may be advantageous to have a liquid cooling system with a mechanism and method for reducing the appearance of stagnating liquid coolant.

### SUMMARY

A liquid cooling system is disclosed. In some examples, the liquid cooling system includes a first heat exchanger configured to transfer heat from a liquid to a refrigerant; and a coolant circuit configured to circulate liquid coolant between the first heat exchanger and at least one of electronic equipment or a cooling distribution unit, the coolant circuit including: a liquid coolant supply line coupled to the first heat exchanger and configured to flow chilled liquid coolant from the first heat exchanger; a coolant return line coupled to the first heat exchanger and configured to flow warmed coolant to the first heat exchanger; and a bypass line coupled to the liquid coolant supply line and the coolant return line.

A cooling system is disclosed. In some examples, the cooling system includes at least one refrigeration circuit including: at least one compressor configured to pressurize a refrigerant; at least one condenser configured to transfer heat from the refrigerant to an outside environment; a first heat exchanger configured to transfer heat from a liquid coolant to the refrigerant; a first heat exchanger configured to transfer heat from ambient air to the refrigerant; a coolant circuit configured to circulate liquid coolant between the first heat exchanger and at least one of electronic equipment or a cooling distribution unit, the coolant circuit including: a coolant supply line coupled to the first heat exchanger and configured to flow chilled liquid coolant from the first heat exchanger; a coolant return line coupled to the first heat exchanger and configured to flow warmed coolant to the first heat exchanger; and a bypass line coupled to the liquid coolant supply line and the coolant return line.

A method for circulating coolant through a bypass line of a liquid cooling subsystem of a hybrid-cooling system is disclosed. In some examples, the method includes: operating the hybrid-cooling system in an air-cooling mode, wherein no refrigerant is flowing through a first heat exchanger of the liquid-cooling system, and refrigerant is flowing through a second heat exchanger of a air-cooling subsystem; switching a bypass valve of the bypass line from a closed position to an open position; and operating one or more coolant pumps, wherein operating the one or more coolant pumps causes coolant to circulate through the bypass line.

It is to be understood that both the foregoing general description and the following detailed description are exemplary and explanatory only and are not necessarily restrictive of the present disclosure. The accompanying drawings, which are incorporated in and constitute a part of the specification, illustrate subject matter of the disclosure. Together, the descriptions and the drawings serve to explain the principles of the disclosure.

### BRIEF DESCRIPTION OF THE DRAWINGS

The numerous advantages of the disclosure may be better understood by those skilled in the art by reference to the accompanying figures.
FIG. 1A illustrates a block diagram of a cooling system for liquid cooling of electronic equipment, in accordance with one or more examples of the disclosure.
FIG. 1B illustrates a cooling system for hybrid cooling of electronic equipment, in accordance with one or more examples of the disclosure.
FIG. 2 illustrates a cooling system for hybrid cooling of electronic equipment, in accordance with one or more examples of the disclosure.
FIG. 3 illustrates a cooling system for hybrid cooling of electronic equipment, in accordance with one or more examples of the disclosure.
FIG. 4 illustrates a schematic view of the hybrid cooling system, in accordance with one or more examples of the disclosure.
FIG. 5 illustrates a schematic view of the hybrid cooling system operating in 100% air-cooling mode, in accordance with one or more examples of the disclosure.
FIG. 6 illustrates a schematic view of the hybrid cooling system operating in 100% liquid-cooling mode, in accordance with one or more examples of the disclosure.
FIG. 7 illustrates a schematic view of the hybrid cooling system operating in approximately 50% air-cooling mode, in accordance with one or more examples of the disclosure.
FIG. 8 illustrates a schematic view of the hybrid cooling system operating with multiple refrigeration circuits, in accordance with one or more examples of the disclosure.
FIG. 9 illustrates a form factor and housing for the cooling system, in accordance with one or more examples of the disclosure.
FIG. 10 illustrates a schematic view of a portion of the cooling system, in accordance with one or more examples of the disclosure.
FIG. 11 illustrates a process flow diagram depicting a method for circulating coolant through a bypass line of liquid cooling subsystem of a hybrid-cooling system, in accordance with one or more examples of the disclosure.

### DETAILED DESCRIPTION

Before explaining one or more examples of the disclosure in detail, it is to be understood that the examples are not limited in their application to the details of construction and the arrangement of the components or steps or methodologies set forth in the following description or illustrated in the drawings. In the following detailed description of examples, numerous specific details may be set forth in order to provide a more thorough understanding of the disclosure. However, it will be apparent to one of ordinary skill in the art having the benefit of the instant disclosure that the examples disclosed herein may be practiced without some of these specific details. In other instances, well-known features may not be described in detail to avoid unnecessarily complicating the instant disclosure.

As used herein a letter following a reference numeral is intended to reference an example of the feature or element that may be similar, but not necessarily identical, to a previously described element or feature bearing the same reference numeral (e.g., 1, 1a, 1b). Such shorthand notations are used for purposes of convenience only and should not be construed to limit the disclosure in any way unless expressly stated to the contrary.

Further, unless expressly stated to the contrary, "or" refers to an inclusive or and not to an exclusive or. For example, a condition A or B is satisfied by any one of the following: A is true (or present), and B is false (or not present), A is false (or not present) and B is true (or present), and both A and B are true (or present).

In addition, the use of "a" or "an" may be employed to describe elements and components of examples disclosed herein. This is done merely for convenience and "a" and "an" are intended to include "one" or "at least one," and the singular also includes the plural unless it is obvious that it is meant otherwise.

Finally, as used herein any reference to "one example" or "examples" means that a particular element, feature, structure, or characteristic described in connection with the example is included in at least one example disclosed herein. The appearances of the phrase "in examples" in various places in the specification are not necessarily all referring to the same example, and examples may include one or more of the features expressly described or inherently present herein, or any combination or sub-combination of two or more such features, along with any other features which may not necessarily be expressly described or inherently present in the instant disclosure.

Disclosed is a system and method for circulating coolant through a bypass line of a liquid cooling system (or subsystem). In examples, the liquid cooling system includes a refrigeration circuit that uses a compressor to compress a refrigerant for use in cooling. The liquid cooling system also includes a coolant circuit circulating coolant that is cooled by the refrigerant via a liquid heat exchanger, such as a braze plate heat exchanger (BPHE). The coolant is then used to cool down electronic equipment via the coolant circuit. In examples, the coolant circuit includes a bypass line that allows the coolant circuit to circulate regardless of the operational state of the refrigerant circuit. Circulating the coolant prevents stagnation of the coolant, which can result in biological growth, sediment buildup, and chemical degradation, severely compromising the efficiency and reliability of the liquid cooling system.

In examples, the liquid cooling system, including the coolant circuit and the bypass line, may be considered as, or incorporated into, a hybrid air/liquid cooling system. For example, the liquid cooling system may include componentry for cooling densified IT loads via liquid (e.g., water or propylene glycol) as the working medium. In another example, the hybrid air/liquid cooling system may include a heat exchanger configured as an evaporator coil typically used in air cooling systems, and the aforementioned liquid cooling heat exchanger. The hybrid air/liquid cooling system may be designed to provide cooling that is 100% air-cooled, 100% liquid-cooled, or a balance of both air cooling and liquid cooling. The hybrid air/liquid cooling system may be initially built as a complete hybrid cooling system or be built sequentially by installing and integrating a liquid cooling componentry (e.g., a liquid cooling subsystem) with a legacy air-cooling system. In examples, the hybrid cooling system is configured such that the coolant may be cycled through the bypass line while the system is operating under an air-cooling mode. The flow of coolant through the bypass line may be controlled by a bypass valve that may operate while the system is operating under the air-cooled mode.

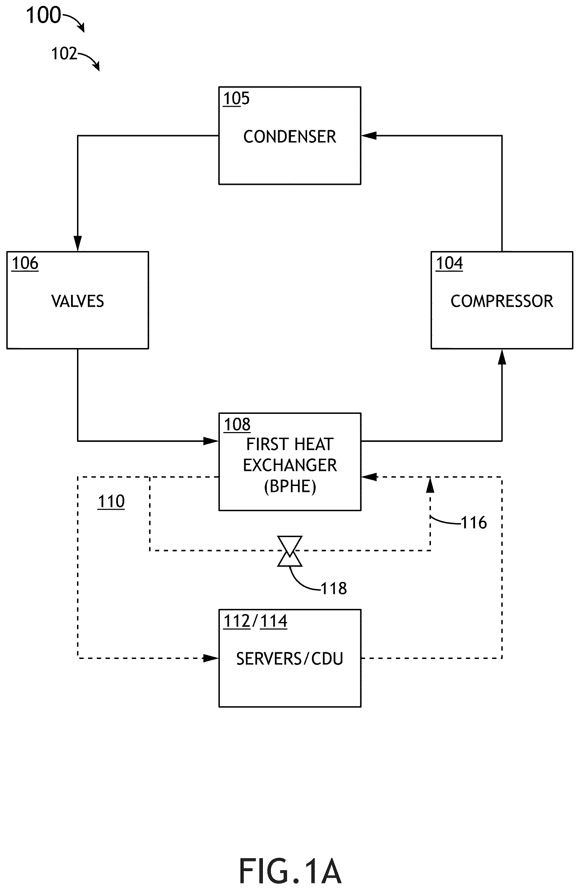

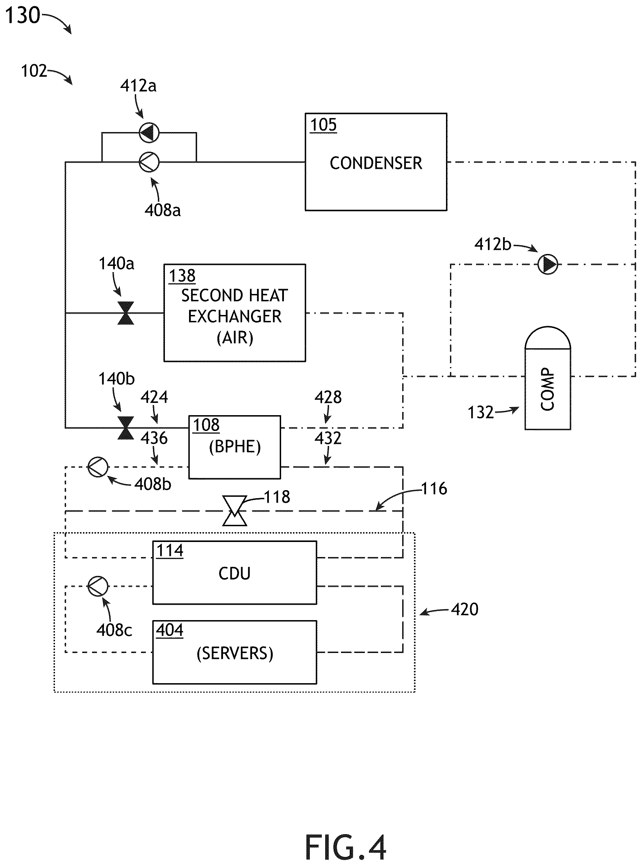

FIG. 1A illustrates a block diagram of a cooling system 100 for liquid cooling of electronic equipment (e.g., a server or server farm/data center), in accordance with one or more examples of the disclosure. The cooling system includes a refrigeration circuit 102 that may include a compressor 104, a condenser 105, a set of valves 106, and a first heat exchanger 108 (e.g., a liquid heat exchanger such as a BPHE). The cooling system 100 may further include a coolant circuit 110 that circulates coolant between the first heat exchanger 108 and electronic equipment (e.g., servers 112) and/or a cooling distribution unit (e.g., CDU 114 in FIG. 4).

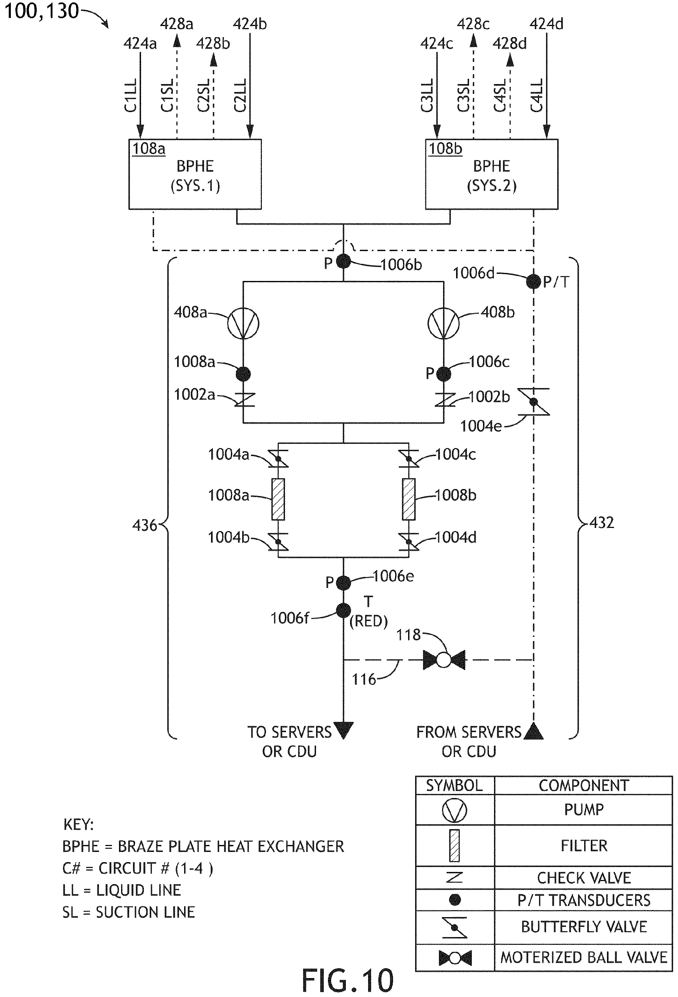

In examples, the cooling system 100 includes a bypass line 116 configured to cycle and/or flow coolant, preventing coolant within the coolant circuit 110 from becoming stagnant. Control of coolant through the coolant circuit 110 may be controlled by one or more bypass valves 118. The one or more bypass valves 118 may be disposed on the ends of the bypass line 116, or at any point along the bypass line 116. Details of the bypass line are shown in FIG. 10.

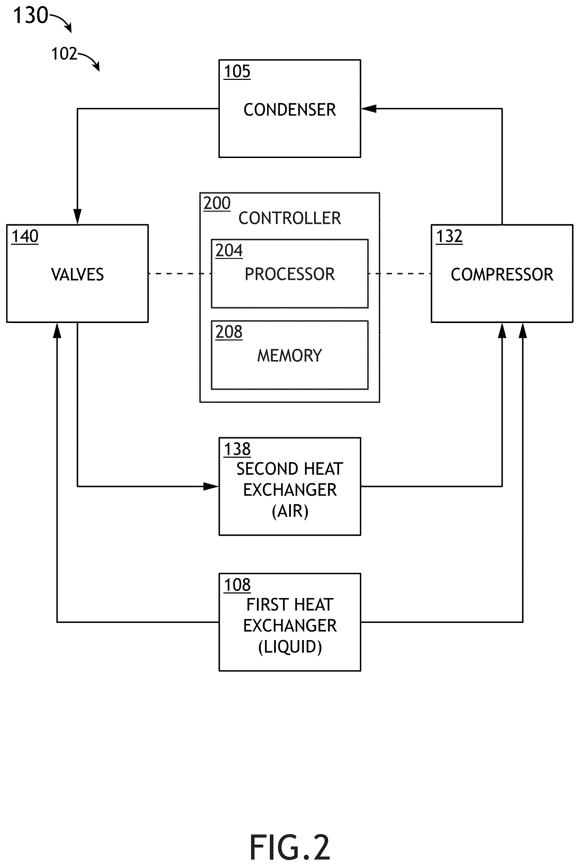

In examples, one or more components of the cooling system 100 are incorporated into a legacy cooling system. For example, the cooling system 100 may be implemented into an air-cooled cooling system, forming a hybrid cooling system. The hybrid cooling system may also refer to a cooling system that includes the liquid cooling subsystem 300 but not an air-cooled subsystem 304. Examples of a hybrid cooling system are shown in FIGS. 2-9.

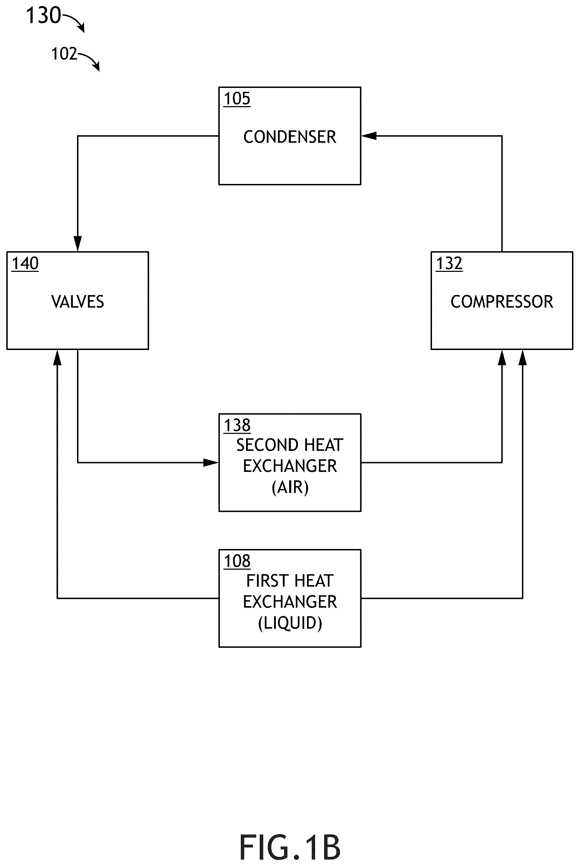

FIG. 1B illustrates a cooling system 130 for hybrid cooling of electronic equipment (e.g., a server or server farm/data center), in accordance with one or more examples of the disclosure. The cooling system 130 may include one or more components of cooling system 100, and vice versa. The cooling system 130 includes one or more compressors 132 configured to pressurize a refrigerant (e.g., a gas refrigerant) within the cooling system 130. Pressurizing the refrigerant raises the temperature of the refrigerant higher than the ambient temperature of the air outside of the cooling system 130. The cooling system 130 may use any type of refrigerant, including, but not limited to, R22, R410A, R407C, R744, R134a, R1234yf, R290, R600a, R718, and R454B.

In examples, the cooling system 130 includes one or more refrigeration circuits 102 that include one or more condensers 105 containing one or more condenser coils. The one or more condensers 105 transfer heat from the refrigerant to an outside environment (e.g., outside of the cooling system 130). For example, the air (e.g., ambient temperature air) may be blown across the condenser coil by a fan. Heat is then transferred from the refrigerant (e.g., vapor refrigerant) to the air of the outside environment. This condenses the refrigerant into a liquid. The colder refrigerant then heads back to an evaporator coil to recollect heat. As used herein, a component of the cooling system 130 may also be a component of the one or more refrigeration circuits 102.

In examples, the cooling system 130 includes a second heat exchanger 138 configured to transfer heat from ambient air to the refrigerant. The second heat exchanger 138 may include a coil. When in use, heated air is blown across one or more coils of the second heat exchanger 138, causing the refrigerant to evaporate into a vapor/gas. This heat transfer cools the air, which is then returned to the electronic equipment to elicit the cooling effect.

In examples, the cooling system 130 includes a set of one or more valves 140 (e.g., expansion valves). The one or more valves 140 facilitate control of the flow of the refrigerant selectively through the second heat exchanger 138 and a first heat exchanger 108 (a liquid heat exchanger (BPHE) to the one or more compressors 132. The one or more valves 140 control one or more qualities of the refrigerant, such as the percentage of refrigerant flowing as a liquid or as a gas/vapor, and ensures that the refrigerant is in gas/vapor form before returning to the compressors 132, as liquids are incompressible and may damage the one or more compressors 132.

In examples, the cooling system 130 includes the first heat exchanger 108. The first heat exchanger 108 is configured to transfer heat from a secondary liquid (e.g., liquid coolant from a secondary cooling system) to the refrigerant. For example, the first heat exchanger 108 may transfer heat from the secondary fluid, e.g., water or propylene glycol, to the refrigerant. The first heat exchanger 108 may include, but not be limited to a brazed plate heat exchanger (BPHE). A BPHE uses both conduction and convection to transfer heat as the coolant passes through the plates of the BPHE, without a need for a blower or fan. Within the one or more refrigeration circuits 102, the second heat exchanger 138 and the first heat exchanger 108 utilize the same refrigerant (e.g., a portion of the refrigerant that has flowed through the second heat exchanger 138 will also flow through the first heat exchanger 108).

In examples, the cooling system 130 includes a controller 200 configured to control one or more processes within the cooling system 130, as shown in FIG. 2. For example, the controller 200 may control the action of the one or more valves 140 of the system. The controller 200 may control other aspects or components of the cooling system 130, including but not limited to, one or more compressors 132, and one or more fans/blowers operating within the cooling system 130. The controller 200 includes one or more processors 204 and memory 208 that facilitate the controller 200 in controlling one or more functions of the cooling system 130. In examples, the one or more processors 204 are configured to receive instructions (e.g., from memory 208 or from an input from an operator via a user interface) to open or close one or more valves 140 of the set of valves, as described herein. In examples, the one or more processors 204 are configured to transmit a signal to the one or more valves 140 of the set of valves based on the instruction, as described herein.

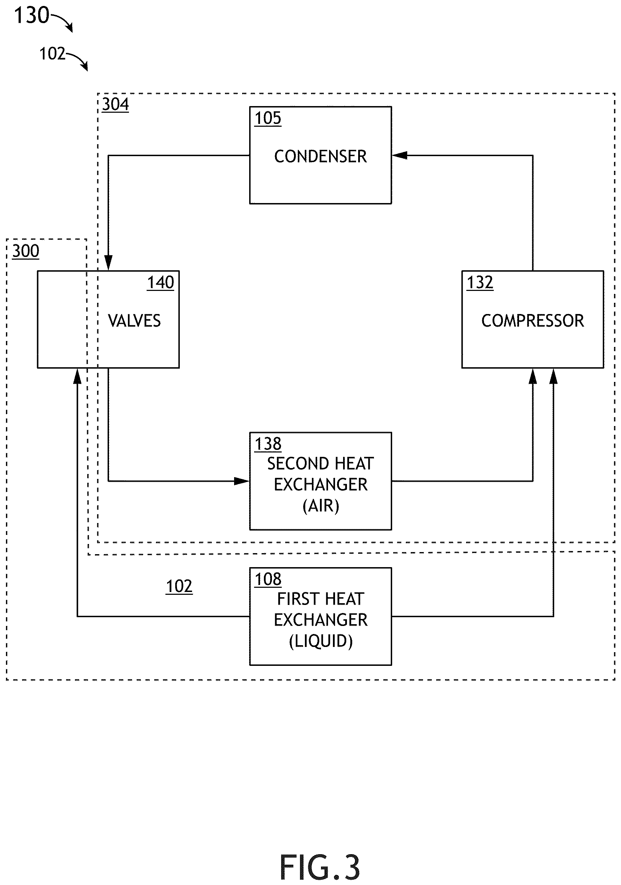

In examples, a liquid cooling subsystem 300 of the hybrid cooling system 130 is disclosed, in accordance with one or more examples of the disclosure, as shown in FIG. 3. In examples, the liquid cooling subsystem 300 includes the first heat exchanger 108 (e.g., the BPHE). The liquid cooling subsystem 300 may also include one or more valves 140 of the set of valves. In examples, the liquid cooling subsystem 300 is added to, or integrated with, another cooling system to form the hybrid cooling system 130. For example, the liquid cooling subsystem 300 can be added to, or integrated with, an air-cooling subsystem 304 or legacy air-cooling subsystem (e.g., an air-cooling subsystem that includes the second heat exchanger 138 and other componentry to create a hybrid cooling system 130). Therefore, the cooling system 130 of this application may include the liquid cooling subsystem 300 that is integrated into a preexisting air-cooled subsystem or may include both the liquid cooling subsystem and a new or preexisting air-cooled subsystem. It should be noted that the cooling systems 100 include the bypass line 116 and bypass valve 118, but are not included in FIGS.1B to 3 for the sake of clarity. Therefore, the above description should not be interpreted as a limitation on the examples of the present disclosure, but merely as an illustration.

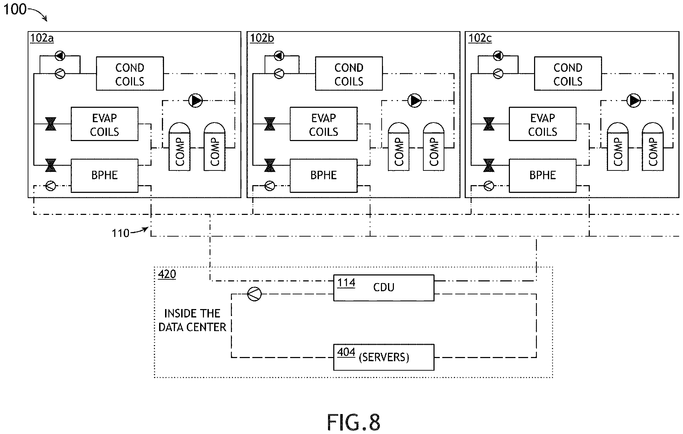

A schematic view of the cooling system 130 is shown in FIG. 4, in accordance with one or more examples of the disclosure. In examples, with reference to FIG. 8, the cooling system 130 includes and/or is in fluid communication with, a CDU 114. The CDU 114 receives chilled secondary fluid (e.g., liquid coolant) from the first heat exchanger 108 and circulates the chilled secondary fluid, or a chilled tertiary fluid (e.g., water, propylene glycol or other coolant) that has exchanged heat with the secondary fluid via the CDU 114, to the electronic equipment 404 (e.g., servers). The electronic equipment 404 heats up the secondary fluid or tertiary fluid, and heat from these fluids is transferred back to the first heat exchanger 108 via circulation. In examples, the secondary fluid may also be circulated directly between the first heat exchanger 108 and the electronic equipment 404 (e.g., the CDU 114 being optional).

As shown in FIG. 4, the cooling system 130 includes a valve 140b which controls the flow of refrigerant to the first heat exchanger 136, and a valve 140a which controls the flow of refrigerant to the second heat exchanger 108. The cooling system 130 may also include one or more pumps 408a, 408b, 408c. For example, the cooling system 130 may include a pump 408a that facilitates the circulation of refrigerant. In another example, the cooling system 130 may include one or more pumps 408b-c configured to circulate secondary fluid through the first heat exchanger 108, the electronic equipment 404 (e.g., to computer chips within the servers) and/or the CDU 114.

The cooling system 130 may also include one or more check valves 412a and/or 412b configured to prevent backflow of refrigerant. The one or more pumps 408a, 408b, and/or 408c and one or more check valves 412a and/or 412b may be part of a complementary heating system that adds efficiency to the cooling system 130. For example, one or more pumps 408a and check valves 412a and/or 412b may facilitate the circulation of refrigerant without the use of the one or more compressors 132. For instance, in times where the temperature outside is colder than the saturation temperature of the refrigerant, the system 130 may rely on the one or more pumps 408a and check valves 412a and/or 412b to circulate refrigerant in the absence of the compressor, reducing the power expended to circulate refrigerant. Because this aspect of cooling is complementary to compressor-mediated cooling, the one or more pumps 408a and one or more check valves 412a and/or 412b may be optional.

In examples, a portion of the cooling system 130 is physically located within a server environment 420 (e.g., the location of the servers or other electronic equipment 404, such as data centers). For example, the CDU 114 and the electronic equipment 404 being cooled may be located within the server environment 420. In another example, the CDU 114, the electronic equipment 404, and the first heat exchanger 108 may be located within the server environment. In another example, the electronic equipment 404 is within the server environment 420.

In examples, the first heat exchanger 108 is coupled to one or more liquid lines 424 that bring cooled refrigerant into the first heat exchanger 108, and one or more suction lines 428 that remove heated refrigerant from the first heat exchanger 108. In examples, the first heat exchanger 108 is coupled to one or more coolant return lines 432 that flow warmed liquid coolant into the first heat exchanger 108. In examples, the first heat exchanger 108 is coupled to one or more liquid coolant supply lines 436. For example, warmed liquid refrigerant may flow into the first heat exchanger 108 via the coolant return line 432, where the warmed coolant is cooled via the chilled refrigerant flowing in from the liquid lines 424. The now cooled coolant then leaves the first heat exchanger 108 via the liquid coolant supply line 436.

In examples, the cooling systems 100, 130 include the bypass line 116 connecting one or more coolant return lines 432 with one or more liquid coolant supply lines 436. The bypass line 116 allows coolant, such as water or PG-25, to be periodically cycled through the liquid cooling aspects of the hybrid cooling system 130 (e.g., or liquid cooling only systems 100), preventing coolant from stagnating within the cooling system 130. The bypass line 116 may include or be controlled by the bypass valve 118.

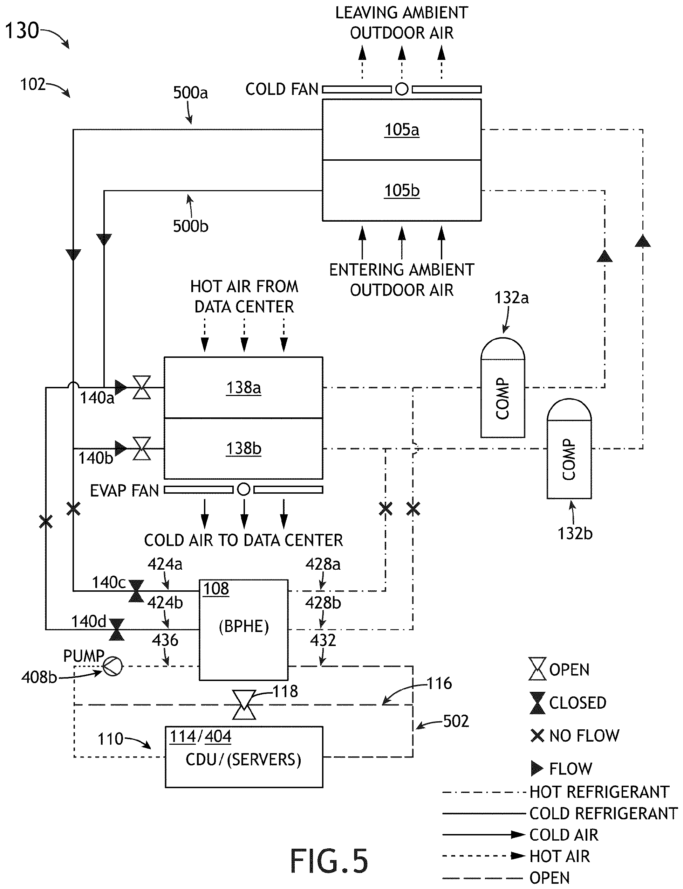

FIGS. 5-7 illustrate a more detailed schematic view of the cooling system 130 operating under different conditions. FIGS. 5-7 illustrate the cooling system 130 with one or more compressors 104a and/or 104b, one or more first heat exchangers 108a, 108b (e.g., liquid-to-air heat exchangers), one or more second heat exchangers 112a and/or 112b (e.g., air-to-air heat exchangers), as well as multiple valves (e.g., second heat exchanger valves 140a, 140b and first heat exchanger valves 140c, 140d). The cooling system 130 may include any number of compressors 132, condensers 105, second one or more heat exchangers 112a and/or 112b, and a first heat exchanger 108. The cooling system 130 may include multiple primary refrigerant circulation loops 500a, 500b (e.g., analogous to refrigeration circuit 102) for circulating refrigerant between the compressors 132 and one or more of the second heat exchanger 138 and the first heat exchanger 108. The cooling system 130 may also include one or more secondary cooling loops 502 (e.g., analogous to coolant circuits 110) for circulating liquid coolant between the first heat exchanger 108 and the CDU 114 or electronic equipment 404. For example, the one or more refrigeration circuits 110 of the cooling system 130 may include, or be in fluid communication with, two secondary cooling loops 502.

FIG. 5 illustrates the cooling system 130 operating with 100% of the cooling performed via the air-cooled second heat exchangers 112a, 112b, in accordance with one or more examples of the disclosure. In this configuration, the second heat exchanger valves 140a, 140b are open (e.g., as indicated by the white valve icon), while the first heat exchanger valves 140c, 140d are closed (e.g., as indicated by the black valve icon), allowing refrigerant to circulate through the second heat exchangers 112a, 112b, and preventing refrigerant from circulating through the first heat exchanger 108. Areas of circulation are denoted with an arrow in FIGS. 5-7, while areas of no flow are denoted by an "x".

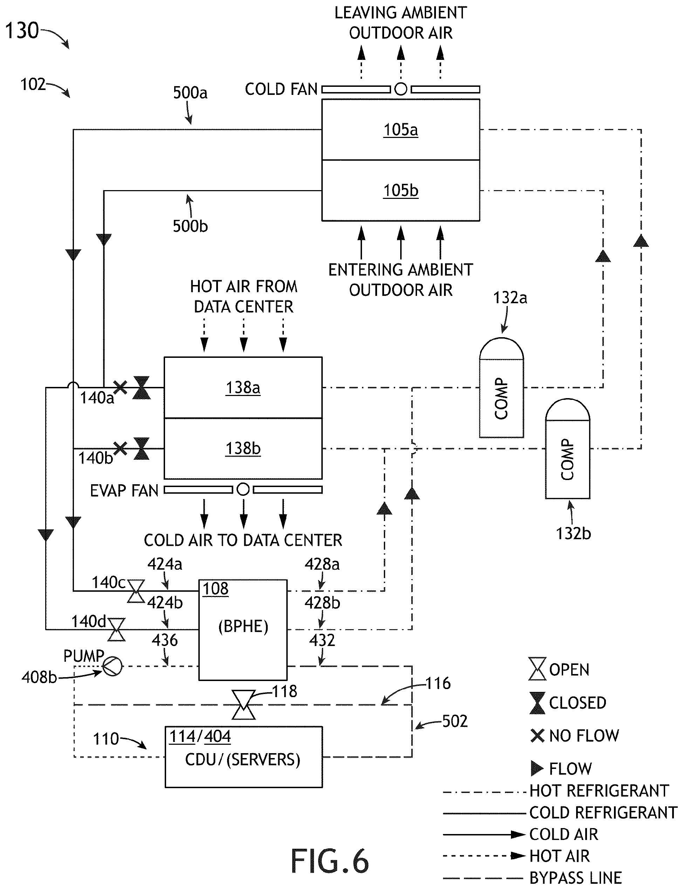

FIG. 6 illustrates the cooling system 130 operating with 100% of the cooling performed via the liquid-cooled first heat exchanger 108, in accordance with one or more examples of the disclosure. In this configuration, the second heat exchanger valves 140a, 140b are closed while the first heat exchanger valves 140c, 140d are open, allowing refrigerant to circulate through the first heat exchanger 108, and preventing refrigerant from circulating through the second heat exchangers 112a, 112b. Areas of circulation are denoted with an arrow, while areas of no flow are denoted by an "x".

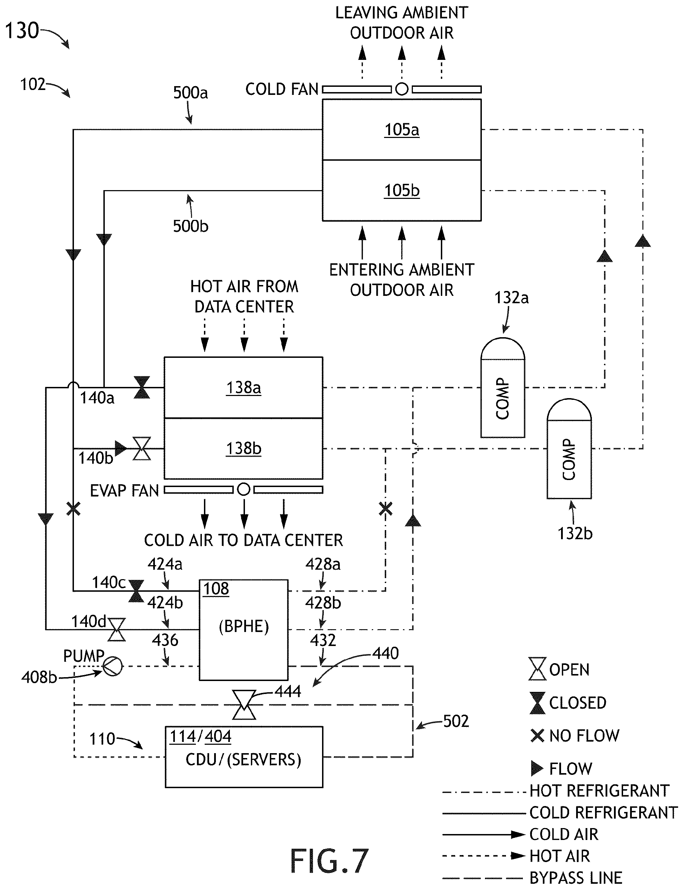

FIG. 7 illustrates a simplified schematic of the cooling system 130 operating with the cooling performed roughly equally between the second heat exchangers 112a, 112b and the liquid-cooled first heat exchanger 108, in accordance with one or more examples of the disclosure. In this configuration, one of the second heat exchanger valves 140a is closed with the other second heat exchanger valve 140b opened, while one of the first heat exchanger valves 140c is closed with the other first heat exchanger valve 140d opened, allowing refrigerant to be cooled by both air-cooling and liquid-cooling technologies. The cooling system 130 may be configured to allow any percentage of cooling to be performed by either the second heat exchanger 138 or the first heat exchanger 108. For example, the ratio of percentages of cooling between the second heat exchangers 138 and the first heat exchanger 108 may be 50% (air):50% (liquid). The switching of the valves 140a-d may be performed manually or via the controller 200.

In examples, the cooling system 130 includes one or more refrigeration circuits 102a, 102b, 102c, in accordance with one or more examples of the disclosure, and as shown in FIG. 8. The cooling system 130 may have any number of refrigeration circuits 102 including, but not limited to one refrigeration circuit 102, two refrigeration circuits 102, three refrigeration circuits 110, ten refrigeration circuits 102, 30 refrigeration circuits 110, or 100 or more refrigeration circuits 102. For example, the cooling system 130 may include up to 32 refrigeration circuits 102. The refrigeration circuits 102a, 102b, 102c may be in fluid communication with any number of CDUs 114 or electronic equipment 404 (e.g., servers) and may be organized in parallel with a set of CDUs 114 or electronic equipment 404. For example, the set of CDUs 114 and/or electronic equipment 404 may be paralleled together up to 32 refrigeration circuits 102.

In examples, one or more processors 204 are configured to receive instructions specific for each set of valves 140 (e.g., ON and OFF instructions) of the one or more refrigeration circuits 102. The one or more processors 204 may also be configured to transfer a signal to the valves 140 based on the instructions for each of the refrigeration circuits 102. For example, for a cooling system 130 with ten refrigeration circuits 102, the cooling system 130 may be instructed to, and be executed by the one or more processors 204 of the controller 200 to, operate the valves 140 so that three of the refrigeration circuits 102 operate with 100% air-cooling and seven of the refrigeration circuits 102 operate with 100% liquid-cooling. In this manner, the ratio of cooling between the second heat exchangers 138 and the first heat exchanger 108 for the entire cooling system 130 can be adjusted based on the opening and closing of valves 140 within each refrigeration circuit 102.

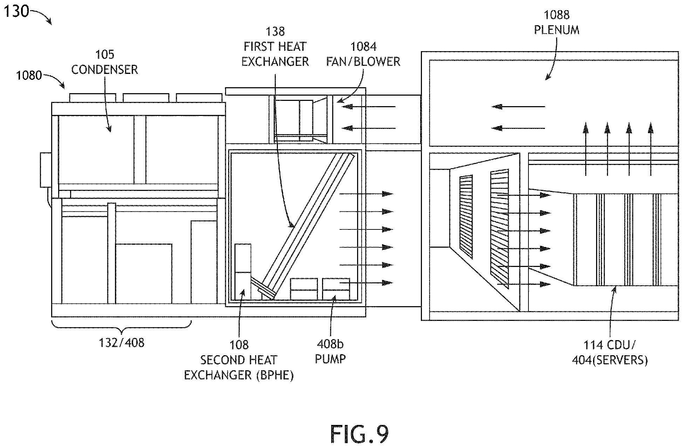

A form factor and housing 900 for the cooling system 130 is shown in FIG. 9, in accordance with one or more examples of the disclosure. The coordinated cooling of refrigerant by the second heat exchanger 138 and the first heat exchanger 108 causes cooled air and/or cooled liquid to enter the electronic equipment 404 (with or without CDUs 114). Air may be circulated by one or more fans/blowers 904. Air that is heated by the electronic equipment 404 then rises into a plenum 908 and may be circulated back to the second heat exchanger 138 for another round of cooling. The cooling system 130 may be designed to fit into one or more form factors. cooling system 130

FIG. 10 illustrates a simplified schematic of a portion of the cooling system 100, 130 in accordance with one or more examples of the disclosure. The cooling system 100, 130 may include one or more first heat exchangers 108 and/or 108b coupled to one or more liquid lines 424a, 424b, 424c, and/or 424d, one or more suction lines 428a, 428b, 428c, and/or 424d, a coolant supply line 436, and a coolant return line 432. The one or more coolant supply lines 436 and/or one or more coolant return lines 432 may include one or more pumps 408a, and/or 408b, one or more check valves 1002a and/or 1002b, one or more butterfly valves 1004a-e, one or more pressure transducers 1006a-f, and one or more filters 1008a-b. The one or more pressure transducers 1006a-f may be configured to measure pressure within the one or more coolant supply lines 436 and/or one or more coolant return lines 432. For example, pressure transducers 1006a-f (e.g., a plurality of pressure transducers 1006) may be positioned upstream and downstream of the one or more filters 1008a-b. The cooling system 100 may include one or more temperature transducers configured to measure a temperature of the one or more coolant supply lines 436 and/or one or more coolant return lines 432.

In examples, the liquid cooling subsystem 300 of the cooling system 100 includes more than one liquid heat exchanger 108a, 108b fluidly coupled to the bypass line 116. For example, the liquid cooling subsystem 300 may include two or more BPHE heat exchangers 108a. 108b fluidly coupled to the bypass line 116.

In examples, the systems 100, 130 may include a different type of valve in place of one or more of the butterfly valves 1004a-e. Also, while the coolant supply line 436 is shown to include considerably more pumps 408, check valves 1002, butterfly valves 1004, pressure transducers 1006, and filters than the coolant return line 432, one or more of those components from the coolant supply line 436 may be integrated into the coolant return line 432. Therefore, the above description should not be interpreted as a limitation on the examples of the present disclosure, but merely as an illustration.

In examples, the cooling systems 100, 130 include the bypass line 116 as described herein. The bypass line 116 allows the cooling system 100, 130 to circulate coolant through a portion of the coolant supply line 436 and the coolant return line 432, preventing coolant (e.g., residual coolant) in the coolant supply line 436 and the coolant return line 432 from becoming stagnant and adversely affecting the cooling system 100, 130 through corrosion, formation of sediment, biological growth, chemical degradation, etc. In examples, the bypass line prevents coolant from circulating coolant through the CDU 114 and/or electronic equipment 404. In examples, the flow of coolant through the bypass line 116 is controlled via one or more bypass valves 118.

The one or more bypass valves 118 may include any type of valve including, but not limited to, ball valves, butterfly valves, globe valves, gate valves, check valves, needle valves, diaphragm valves, pinch valves, and plug valves. For example, the one or more bypass valves 118 may include a motorized ball valve. For instance, the one or more bypass valves 118 may include a motorized ball valve under control of the controller 200.

In examples, the bypass valve 118, and subsequent control of coolant through the bypass line 116, may be operated while the cooling system 130 is operating in air-cooling mode (e.g., not liquid cooling mode). For example, the cooling system 130 may be configured to flow coolant through the bypass line 116 while the cooling system 130 is actively cooling via the second heat exchanger. In another example, the cooling system 130 may be configured to switch the bypass valve 118 between OFF and ON positions while the cooling system 130 is actively cooling via the second heat exchanger 138.

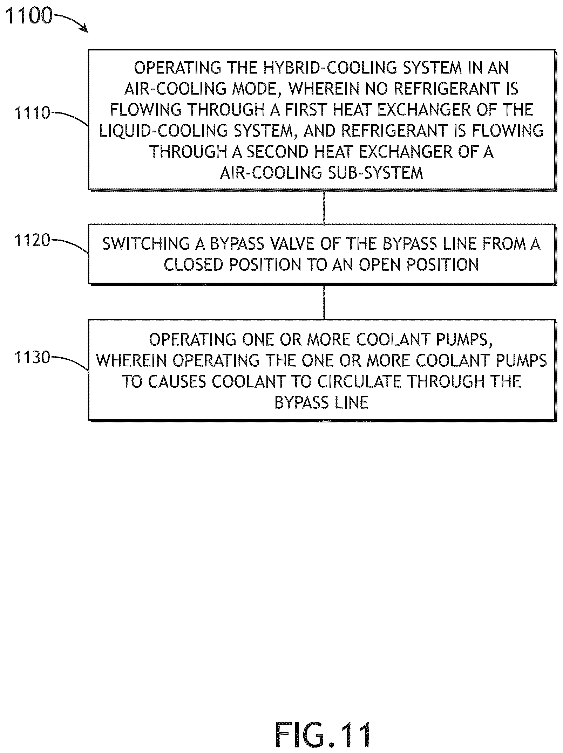

FIG. 11 illustrates a process flow diagram depicting a method 1100 for circulating coolant through a bypass line 116 of a hybrid-cooling system 130, in accordance with one or more examples of the disclosure. The method may be performed routinely (e.g., based on time intervals), whenever there is no load or operation of the first heat exchanger 108, and/or when prompted by an operator via the controller 200. For example, if a cooling system 130 is operating in air-cooling mode, control software of the controller 200 can initiate a circulation routine every 15 or so days, which will send a message to the operator that a routing cycle is going to occur. The controller 200 may then cause the bypass valve 118 to open and run a pump 408 for 10 minutes or so. The controller 200 may then cause the bypass valve 118 to close, cause the pump 408 to stop, then message the operator that the routine is complete.

In examples, the method 1100 includes a step 1110 of operating the hybrid-cooling system 130 in an air-cooling mode. Refrigerant is flowing through a first heat exchanger of the air-cooling subsystem, and refrigerant is not flowing through a first heat exchanger of the liquid cooling subsystem.

In examples, the method 1100 includes a step 1120 of switching a bypass valve 118 of the bypass line 116 from a closed position to an open position. In examples, the method includes a step 1130 of operating one or more coolant pumps 408, The step 1130 causes coolant to circulate through the bypass line 116.

The system 130 and method 1100 described herein may prevent coolant from stagnating within the coolant circuit 110. For example, when traditional liquid cooling units and hybrid cooling units may have water or other coolant in the coolant circuit 110 due to commissioning during production/manufacturing or when switching back and forth between air cooling mode and liquid cooling mode. Circulating coolant via the bypass line 116, ensures that the cooling system 100, 130 remains in optimal condition, ready to handle peak thermal loads when needed, thus safeguarding the performance and components within the coolant circuit 110. Filters 1008a, 1008b may also pick up any sediment that has formed in the system 100, 130. Periodically cycling the coolant will slow, if not prevent, the formation of this sediment and the breakdown of the coolant. By implementing regular coolant circulation automatically with the use of software, data centers can enhance the longevity and effectiveness of their cooling systems 100, 130.

The one or more processors 204 may be implemented as any suitable processor(s), such as at least one general purpose processor, at least one central processing unit (CPU), at least one image processor, at least one graphics processing unit (GPU), at least one field-programmable gate array (FPGA), and/or at least one special purpose processor configured to execute instructions for performing (e.g., collectively performing if more than one processor) any or all of the operations disclosed throughout.

Those having skill in the art will recognize that the state of the art has progressed to the point where there is little distinction left between hardware and software implementations of aspects of systems; the use of hardware or software is generally (but not always, in that in certain contexts the choice between hardware and software can become significant) a design choice representing cost vs. efficiency tradeoffs. Those having skill in the art will appreciate that there are various vehicles by which processes and/or systems and/or other technologies described herein can be implemented (e.g., hardware, software, and/or firmware), and that the preferred vehicle will vary with the context in which the processes and/or systems and/or other technologies are deployed. For example, if an implementer determines that speed and accuracy are paramount, the implementer may opt for a mainly hardware and/or firmware vehicle; alternatively, if flexibility is paramount, the implementer may opt for a mainly software implementation; or, yet again alternatively, the implementer may opt for some combination of hardware, software, and/or firmware. Hence, there are several possible vehicles by which the processes and/or devices and/or other technologies described herein may be implemented, none of which is inherently superior to the other in that any vehicle to be utilized is a choice dependent upon the context in which the vehicle will be deployed and the specific concerns (e.g., speed, flexibility, or predictability) of the implementer, any of which may vary.

The foregoing detailed description has set forth various examples of the devices and/or processes via the use of block diagrams, flowcharts, and/or examples. Insofar as such block diagrams, flowcharts, and/or examples contain one or more functions and/or operations, it will be understood by those within the art that each function and/or operation within such block diagrams, flowcharts, or examples can be implemented, individually and/or collectively, by a wide range of hardware, software, firmware, or virtually any combination thereof. In one example, several portions of the subject matter described herein may be implemented via Application Specific Integrated Circuits (ASICs), Field Programmable Gate Arrays (FPGAs), digital signal processors (DSPs), or other integrated formats. However, those skilled in the art will recognize that some aspects of the examples disclosed herein, in whole or in part, can be equivalently implemented in integrated circuits, as one or more computer programs running on one or more computers (e.g., as one or more programs running on one or more computer systems), as one or more programs running on one or more processors (e.g., as one or more programs running on one or more microprocessors), as firmware, or as virtually any combination thereof, and that designing the circuitry and/or writing the code for the software and/or firmware would be well within the skill of one of skill in the art in light of this disclosure. In addition, those skilled in the art will appreciate that the mechanisms of the subject matter described herein are capable of being distributed as a program product in a variety of forms, and that an illustrative example of the subject matter described herein applies regardless of the particular type of signal bearing medium used to actually carry out the distribution. Examples of a signal bearing medium include, but are not limited to, the following: a recordable type medium such as a floppy disk, a hard disk drive, a Compact Disc (CD), a Digital Video Disk (DVD), a digital tape, a computer memory, etc.; and a transmission type medium such as a digital and/or an analog communication medium (e.g., a fiber optic cable, a waveguide, a wired communications link, a wireless communication link, etc.).

In a general sense, those skilled in the art will recognize that the various aspects described herein which can be implemented, individually and/or collectively, by a wide range of hardware, software, firmware, or any combination thereof can be viewed as being composed of various types of "electrical circuitry." Consequently, as used herein "electrical circuitry" includes, but is not limited to, electrical circuitry having at least one discrete electrical circuit, electrical circuitry having at least one integrated circuit, electrical circuitry having at least one application-specific integrated circuit, electrical circuitry forming a general purpose computing device configured by a computer program (e.g., a general purpose computer configured by a computer program which at least partially carries out processes and/or devices described herein, or a microprocessor configured by a computer program which at least partially carries out processes and/or devices described herein), electrical circuitry forming a memory device (e.g., forms of random access memory), and/or electrical circuitry forming a communications device (e.g., a modem, communications switch, or optical-electrical equipment). Those who have skill in the art will recognize that the subject matter described herein may be implemented in an analog or digital fashion or some combination thereof.

Those having skill in the art will recognize that it is common within the art to describe devices and/or processes in the fashion set forth herein, and thereafter use engineering practices to integrate such described devices and/or processes into data processing systems. That is, at least a portion of the devices and/or processes described herein can be integrated into a data processing system via a reasonable amount of experimentation. Those having skill in the art will recognize that a typical data processing system generally includes one or more of a system unit housing, a video display device, a memory such as volatile and non-volatile memory, processors such as microprocessors and digital signal processors, computational entities such as operating systems, drivers, graphical user interfaces, and applications programs, one or more interaction devices, such as a touch pad or screen, and/or control systems including feedback loops and control motors (e.g., feedback for sensing position and/or velocity; control motors for moving and/or adjusting components and/or quantities). A typical data processing system may be implemented utilizing any suitable commercially available components, such as those typically found in data computing/communication and/or network computing/communication systems.

As used throughout and as would be appreciated by those skilled in the art, "at least one non-transitory computer-readable medium" or "memory 208" may refer to as at least one non-transitory computer-readable medium (e.g., e.g., at least one computer-readable medium implemented as hardware; e.g., at least one non-transitory processor-readable medium, at least one memory (e.g., at least one nonvolatile memory, at least one volatile memory, or a combination thereof; e.g., at least one random-access memory, at least one flash memory, at least one read-only memory (ROM) (e.g., at least one electrically erasable programmable read-only memory (EEPROM)), at least one on-processor memory (e.g., at least one on-processor cache, at least one on-processor buffer, at least one on-processor flash memory, at least one on-processor EEPROM, or a combination thereof), or a combination thereof), at least one storage device (e.g., at least one hard-disk drive, at least one tape drive, at least one solid-state drive, at least one flash drive, at least one readable and/or writable disk of at least one optical drive configured to read from and/or write to the at least one readable and/or writable disk, or a combination thereof), or a combination thereof).

The herein described subject matter sometimes illustrates different components contained within, or connected with, different other components. It is to be understood that such depicted architectures are merely exemplary, and that in fact many other architectures can be implemented which achieve the same functionality. In a conceptual sense, any arrangement of components to achieve the same functionality is effectively "associated" such that the desired functionality is achieved. Hence, any two components herein combined to achieve a particular functionality can be seen as "associated with" each other such that the desired functionality is achieved, irrespective of architectures or intermedial components. Likewise, any two components so associated can also be viewed as being "operably connected", or "operably coupled", to each other to achieve the desired functionality, and any two components capable of being so associated can also be viewed as being "operably couplable", to each other to achieve the desired functionality. Specific examples of operably couplable include but are not limited to physically mateable and/or physically interacting components and/or wirelessly interactable and/or wirelessly interacting components and/or logically interacting and/or logically interactable components.

While particular aspects of the present subject matter described herein have been shown and described, it will be apparent to those skilled in the art that, based upon the teachings herein, changes and modifications may be made. It is to be understood that the invention is defined by the appended claims.

Described herein are also the following clauses:
1. A liquid cooling system, the liquid cooling system comprising: a first heat exchanger configured to transfer heat from a liquid to a refrigerant; and a coolant circuit configured to circulate liquid coolant between the first heat exchanger and at least one of electronic equipment or a cooling distribution unit, the coolant circuit comprising: a liquid coolant supply line coupled to the first heat exchanger and configured to flow chilled liquid coolant from the first heat exchanger; a coolant return line coupled to the first heat exchanger and configured to flow warmed coolant to the first heat exchanger; and a bypass line coupled to the liquid coolant supply line and the coolant return line.
2. The liquid cooling system of clause 1, wherein the bypass line comprises a bypass valve configured to switch between an open configuration and a closed configuration, and wherein, when the bypass valve is in an open configuration, the liquid coolant bypasses circulation to the at least one of the electronic equipment or the cooling distribution unit.
3. The liquid cooling system of clause 2, wherein the bypass valve comprises a ball valve operatively coupled to a controller.
4. The cooling system of clause 1, wherein at least one of the liquid coolant supply line or the liquid return line comprises one or more sediment filters.
5. The cooling system of clause 4, further comprising a plurality of pressure transducers positioned upstream and downstream of at least one of the one or more filters.
6. The cooling system of clause 1, wherein the first heat exchanger comprises a braze plate heat exchanger (BPHE).
7. The cooling system of clause 1, further comprising: one or more coolant pumps; and one or more processors configured to: cause a bypass valve to switch to an open position, and cause one or more coolant pumps to operate, wherein causing the bypass valve to switch to an open position and causing one or more coolant pumps to operate causes coolant to circulate through the bypass line.
8. The cooling system of clause 1, further comprising a second heat exchanger configured to transfer heat from a liquid to a refrigerant, wherein the first heat exchanger and the second heat exchanger are fluidly coupled to the bypass line.
9. The cooling system of clause 1, wherein the cooling system is configured to remove heat from servers in a data center.
10. A cooling system comprising: at least one refrigeration circuit comprising: at least one compressor configured to pressurize a refrigerant; at least one condenser configured to transfer heat from the refrigerant to an outside environment; a first heat exchanger configured to transfer heat from a liquid coolant to the refrigerant; a second heat exchanger configured to transfer heat from ambient air to the refrigerant; and a coolant circuit configured to circulate liquid coolant between the first heat exchanger and at least one of electronic equipment or a cooling distribution unit, wherein the coolant circuit comprises: a coolant supply line coupled to the first heat exchanger and configured to flow chilled liquid coolant from the first heat exchanger; a coolant return line coupled to the first heat exchanger and configured to flow warmed coolant to the first heat exchanger; and a bypass line coupled to the liquid coolant supply line and the coolant return line.
11. The cooling system of clause 10, wherein the bypass line comprises a bypass valve configured to switch between an open configuration and a closed configuration, and wherein, when the bypass valve is in an open configuration, the liquid coolant bypasses circulation to the at least one of the electronic equipment or the cooling distribution unit.
12. The cooling system of clause 11, wherein the bypass valve comprises a ball valve coupled to a controller.
13. The cooling system of clause 10, wherein at least one of the liquid coolant supply line or the liquid return line comprises one or more sediment filters.
14. The cooling system of clause 13, further comprising a plurality of pressure transducers positioned upstream and downstream of at least one of the one or more filters.
15. The cooling system of clause 10, wherein the first heat exchanger comprises a braze plate heat exchanger (BPHE).
16. The cooling system of clause 10, further comprising: one or more coolant pumps; and one or more processors configured to: cause a bypass valve to switch to an open position, and cause one or more coolant pumps to operate, wherein causing the bypass valve to switch to an open position and causing one or more coolant pumps to operate causes coolant to circulate through the bypass line.
17. The cooling system of clause 10, further comprising another first heat exchanger configured to transfer heat from a liquid to a refrigerant, wherein the first heat exchanger and the another first heat exchanger are fluidly coupled to the bypass line.
18. The cooling system of clause 10, wherein the cooling system is configured to remove heat from servers in a data center.
19. A method for circulating coolant through a bypass line of a liquid cooling subsystem of a hybrid-cooling system, the method comprising: operating the hybrid-cooling system in an air-cooling mode, wherein no refrigerant flows through a first heat exchanger of the liquid cooling subsystem, and refrigerant flows through a second heat exchanger of an air-cooling subsystem; switching a bypass valve of the bypass line from a closed position to an open position; and operating one or more coolant pumps, wherein operating the one or more coolant pumps causes coolant to circulate through the bypass line.
20. The method of clause 19, wherein operating the one or more coolant pumps causes coolant to flow across one or more filters.

## Claims

1. A cooling system, the cooling system comprising:
a first heat exchanger configured to transfer heat from a liquid to a refrigerant; and
a coolant circuit configured to circulate liquid coolant between the first heat exchanger and at least one of electronic equipment or a cooling distribution unit,
the coolant circuit comprising:
a liquid coolant supply line coupled to the first heat exchanger and configured to flow chilled liquid coolant from the first heat exchanger;
a coolant return line coupled to the first heat exchanger and configured to flow warmed coolant to the first heat exchanger; and
a bypass line coupled to the liquid coolant supply line and the coolant return line.

2. The cooling system of claim 1, wherein the bypass line comprises a bypass valve configured to switch between an open configuration and a closed configuration, and
wherein, when the bypass valve is in an open configuration, the liquid coolant bypasses circulation to the at least one of the electronic equipment or the cooling distribution unit.

3. The cooling system of claim 2, wherein the bypass valve comprises a ball valve operatively coupled to a controller.

4. The cooling system of any preceding claim, wherein at least one of the liquid coolant supply line or the liquid return line comprises one or more sediment filters.

5. The cooling system of claim 4, further comprising a plurality of pressure transducers positioned upstream and downstream of at least one of the one or more sediment filters.

6. The cooling system of any preceding claim, wherein the first heat exchanger comprises a braze plate heat exchanger (BPHE).

7. The cooling system of any preceding claim, further comprising:
one or more coolant pumps; and
one or more processors configured to:
cause a bypass valve to switch to an open position, and
cause one or more coolant pumps to operate, wherein causing the bypass valve to switch to an open position and causing one or more coolant pumps to operate causes coolant to circulate through the bypass line.

8. The cooling system of any preceding claim, further comprising a second heat exchanger configured to transfer heat from a liquid to a refrigerant, wherein the first heat exchanger and the second heat exchanger are fluidly coupled to the bypass line.

9. The cooling system of any preceding claim, wherein the cooling system is configured to remove heat from servers in a data center.

10. The cooling system of any preceding claim, further comprising:
at least one compressor configured to pressurize the refrigerant;
at least one condenser configured to transfer heat from the refrigerant to an outside environment;
a second heat exchanger configured to transfer heat from ambient air to the refrigerant.

11. A method for circulating coolant through a bypass line of a liquid cooling subsystem of a cooling system, the method comprising:
operating the cooling system in an air-cooling mode, wherein no refrigerant flows through a first heat exchanger of the liquid cooling subsystem, and refrigerant flows through a second heat exchanger of an air-cooling subsystem;
switching a bypass valve of the bypass line from a closed position to an open position; and
operating one or more coolant pumps, wherein operating the one or more coolant pumps causes coolant to circulate through the bypass line.

12. The method of claim 11, wherein operating the one or more coolant pumps causes coolant to flow across one or more filters.

13. The method of any one of the claims 11 to 12,
further comprising periodically operating the cooling system in the air-cooling mode.

14. The method of any one of the claims 11 to 13,
further comprising initiating the air-cooling mode by an operator.

15. The method of any one of the claims 11 to 14, wherein
the cooling system is the cooling system according to any one of the claims 1 to 10.
